# EUROPEAN PATENT SPECIFICATION

(11) **EP 3 774 077 B1**
(45) Date of publication and mention of the grant of the patent: **07.06.2023**
(21) Application number: 19763057.7
(22) Date of filing: 30.08.2019
(51) Int. Cl.: B05D 1/00, C23C 14/12, C23C 16/50, H01J 37/32

(54) **APPARATUS AND METHOD FOR DEPOSITING A POLY(P-XYLYLENE) FILM ON A COMPONENT**
VORRICHTUNG UND VERFAHREN ZUM ABLAGERN EINES POLY (P-XYLYLEN) -FILMS AUF EINEM KOMPONENT
APPAREIL ET PROCÉDÉ DE DÉPÔT D'UN FILM DE POLY (P-XYLYLÈNE) SUR UN COMPOSANT

(30) Priority: 31.08.2018 GB 201814231
(43) Date of publication of application: 17.02.2021
(73) Proprietor: University of Surrey, Surrey GU2 7XH (GB); Airbus Defence and Space GmbH, 82024 Taufkirchen (DE)
(72) Inventor: RODRIGUEZ, José Virgilio Anguita, Hook, Hampshire RG27 9PW (GB); SILVA, Sembukuttiarachilage Ravi Pradip, Camberley, Surrey GU15 2ND (GB)
(74) Representative: Petty, Catrin Helen
(86) International application number: PCT/GB2019/052419
(87) International publication number: WO 2020/044053

(56) References cited:
- EP-A2- 1 018 527
- JP-A- 2018 090 868
- US-A- 4 500 562
- US-A- 4 921 723
- US-A- 5 355 832
- US-A1- 2018 005 814

## Description

The present invention relates to an apparatus for applying a poly(p-xylylene) film to a component, and in particular to an electrically conductive component or an insulating component coupled to an electromagnetic field. The invention extends to a method of applying the poly(p-xylylene) film to the component.

Poly(p-xylylene) polymer, sold under the trade name Parylene^{™}, is a material that is deposited in thin-film form on a variety of commercial products. The poly(p-xylylene) polymer film is used to seal the products from exposure to an external environment. Accordingly, the film may protect a component from moisture and/or corrosive elements or may make component to become biocompatible.

Poly(p-xylylene) polymer deposition takes place inside a vacuum chamber, where the components to be coated are placed. For this, the chamber is evacuated, and a vapour of the poly(p-xylylene) monomer is injected into the chamber. The monomer condenses on the surface of the components where it polymerises, forming the protective parylene coating.

However, it can be difficult to obtain a uniform coating on a component with a complex geometry. Carrier gases, such as argon, can be used to improve uniformity. However, these gases also increase dust formed due to monomers binding to each other prematurely in the vapour phase. Dust particles are often the source of defects, such as pin-holes. Accordingly, it is desirable to avoid dust formation.

Furthermore, the monomer may also deposit on the walls of the vacuum chamber as well as on the component. This leads to a waste of the raw material, a reduction in the coating speed, and also requires a large amount of down-time between deposition cycles to allow the vacuum chamber to be cleaned.

US 5,355,832 describes an apparatus adapted for depositing one or more polymeric materials on the surface of a substrate. The apparatus includes a polymerization chamber; an inlet for admitting a glow discharge polymerization precursor into the polymerization chamber; a first conductive member extending into the polymerization chamber; a first conductive support attached to the first conductive member for holding a substrate; a power generator arranged for transmitting electrical energy to the first conductive member; a second conductive member on or within the polymerization chamber, the second conductive member being spaced and insulated from the first conductive member; and a pump arranged for applying a vacuum to the polymerization chamber. A glow discharge zone is established within the polymerization chamber when a vacuum is applied thereto and electrical energy from the first conductive member is received by the second conductive member. Also disclosed is a process of depositing polymeric materials on the surface of a substrate, which can be practiced using the apparatus.

The present invention arises from the inventors work in attempting to overcome the problems associated with the prior art. The invention is defined by the appended claims.

In accordance with a first aspect, there is provided an apparatus for depositing poly(p-xylylene) onto a component, according to claim 1, the apparatus comprising:
- a radio-frequency electrical power supply configured to operate at a frequency between 1 and 100 MHz;
- a deposition chamber;
- a platen disposed inside the deposition chamber and comprising an electrically conductive material, wherein the platen is electrically connected to an electrical power supply and configured to support a component;
- an electrode, either disposed in the deposition chamber or defined by the deposition chamber, wherein the electrode is electrically insulated from the platen;
- a pyrolysis oven, comprising a first heating element configured to heat the pyrolysis oven to a first elevated temperature sufficient to cause pyrolysis of a poly(p-xylylene) dimer;
- a vaporiser oven, comprising a second heating element configured to heat the vaporiser oven to a second elevated temperature sufficient to cause evaporation of the poly(p-xylylene) dimer;
- a first feed means comprising a conduit which extends between the pyrolysis oven and the deposition chamber and being configured to feed a poly(p-xylylene) monomer to the platen; and
- a second feed means comprising a conduit which extends between the vaporiser oven and the pyrolysis oven and being configured to feed the poly(p-xylylene) dimer into the pyrolysis oven,
wherein (i) the platen is configured to support a component comprising an electrically conductive material and the electrical power supply is configured to apply electrical power to the electrically conductive component supported by the platen at a power of between 0.0001 Watts/cm² and 10 Watt/cm² such that a plasma is generated that surrounds the component and ionizes and/or activates the poly(p-xylylene) monomer; or wherein (ii) the platen is configured to support a component consisting of an electrically insulating material and the platen comprises a plate configured to receive the component thereon and the electrical power supply is configured to apply electrical power to the platen (20) at a power of between 0.0001 Watts/cm² and 10 Watt/cm² such that an electrical field is generated, which is able to penetrate through the component (4) and to create a plasma that surrounds the component and ionizes and/or activates the poly(p-xylylene) monomer.

Advantageously, when an electrically conductive component is supported by the platen, and the electrical power supply is activated, the component will act as a virtual electrode. Accordingly, activation of the electrical power supply creates a plasma that surrounds the component to be coated with ionised and/or activated poly(p-xylylene) monomers.

The term "activated" may be understood to mean chemically activated.

Furthermore, the amount of monomers which deposit on the walls of the deposition chamber is significantly reduced. In addition, the inventors have observed a strong improvement in the deposition speed.

The platen may comprise a metal or a conductive composite material. The conductive composite material may comprise a carbon fibre reinforced polymer (CFRP).

The component may comprise an electrically insulating material. The component may consist of an electrically insulating material. The electrically insulating material may comprise a dipole, and more preferably a plurality of dipoles. The, or each, dipole may be an electric dipole. Accordingly, the, or each, dipole may couple to the electrical power supply via the electromagnetic field. The component may comprise a substantially flat surface. The component may have a thickness of less than 25 cm, more preferably less than 10cm, less than 7.5 cm or less than 5 cm, and most preferably less than 3 cm, less than 2 cm or less than 1 cm. The component may comprise a plastic, a glass, an optically transparent material, a paper, a ceramic and/or an elastomer. The optically transparent material may be a material used for manufacturing lenses for use in the visible, ultraviolet and infrared spectrum, such as germanium (Ge), potassium bromide (KBr) and/or sodium chloride (NaCl). Alternatively, or additionally, the component may comprise a glass-fibre reinforced plastic (GFRP).

In embodiments where the component comprises an electrically insulating material, the platen comprises a plate configured to receive the component thereon. The component may be coupled to the platen. Accordingly, an upper surface of the platen may be configured to match a lower surface of the component. Preferably, the plate is substantially flat. The plasma is driven by the platen and, since the component is disposed between the platen and the plasma, the poly(p-xylylene) monomers deposit thereon.

However, in a preferred embodiment, the component comprises an electrically conductive material.

In some embodiments, the component may comprise an electrically insulating material and an electrically conductive material. The electrically conducting material may comprise a mesh disposed within or around the electrically insulating material. Alternatively, the electrically conductive material may define a layer disposed on an outer surface of the electrically insulating material.

Alternatively, the component may consist of an electrically conducting material.

Advantageously, the apparatus of the first aspect can deposit poly(p-xylylene) onto an electrically conductive component with a complex three dimensional shape. The ionised monomers are attracted to the charged component, deposit thereon and polymerise, creating an even layer of poly(p-xylylene), even on complex surfaces. It may be appreciated that any electrically conducting component could be coated with poly(p-xylylene) using the apparatus of the first aspect. Accordingly, the component could comprise a metal, graphite, graphene, carbon nanotubes and/or a conductive composite material. In a preferred embodiment, the component is a carbon fibre reinforced polymer (CFRP).

In embodiments where the component comprises an electrically conductive material, the platen may comprise a plate configured to receive the component thereon. The plate may be as defined above. However, in a preferred embodiment, the platen comprises a resilient clip configured to receive a portion of the electrically conductive component. The resilient clip may comprise a pair of corresponding flanges configured to receive the portion of the electrically conductive component therebetween. Preferably, the portion of the electrically conductive component comprises less than 10% of the surface area of the component, more preferably less than 5%, less than 4% or less than 3% of the surface area of the component, and most preferably less than 2% or less than 1% of the surface area of the component.

Preferably, the apparatus is for use in applying a poly(p-xylylene) film to a component, more preferably for use in applying a poly(p-xylylene) film to an electrically conducting component.

The monomer may be a radical or in an activated chemical state. Accordingly, the exact structure of the monomer may not be known. Accordingly, the monomer may be defined by reference to the structure of the poly(p-xylylene) which it produces. Accordingly, the monomer may be configured to produce a poly(p-xylylene) of formula (I): 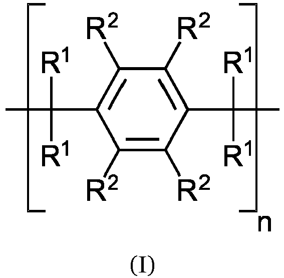 , wherein each R¹ is independently H or a polymer group chain or a halogen; and each R² is independently H, a C₁₋₅ alkyl or a halogen.

Alternatively, or additionally, the poly(p-xylylene) monomer may be a molecule of formula (II): 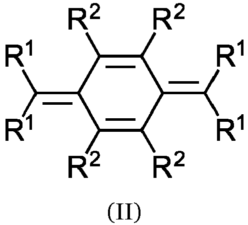 , wherein each R¹ and R² are as defined above.

The halogen may be fluorine, chlorine, bromine or iodine, and is preferably fluorine or chlorine.

In a preferred embodiment, each R¹ is independently H or fluorine; and each R² is independently H or fluorine.

Accordingly, the monomer may be configured to produce a poly(p-xylylene) of formula (Ia), (Ib), (Ic) or (Id):

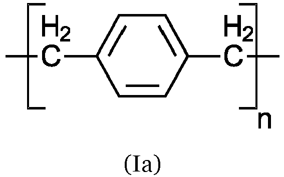

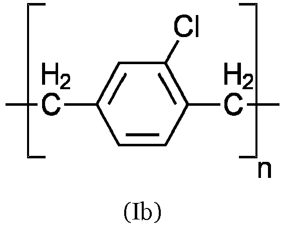

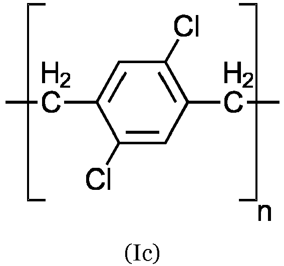

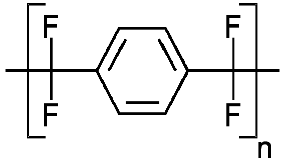

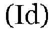

Alternatively or additionally, the poly(p-xylylene) monomer may be a molecule of formula (IIa), (IIb), (IIc) or (IId):

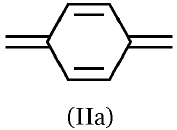

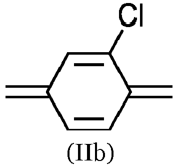

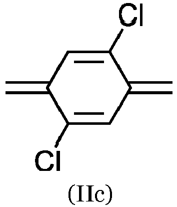

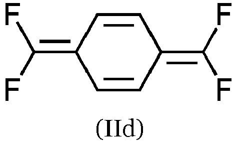

In some embodiments, the electrode may be disposed in the deposition chamber.

However, in a preferred embodiment, the deposition chamber defines the electrode.

Accordingly, the deposition chamber may comprise a conductive material. The conductive material may comprise a metal or a conductive composite material, such as a carbon fibre reinforced polymer (CFRP).

The electrode may be connected to a power supply. However, in a preferred embodiment, the electrode is connected to electrical ground or earth. Accordingly, the electrode may be an earthed electrode. Accordingly, in embodiments where the deposition chamber defines the electrode, the apparatus may comprise an earthed conductive housing.

The apparatus may comprise a vacuum pump. Preferably, the vacuum pump is configured to reduce the pressure of the deposition chamber to a pressure of less than 10 Torr, less than 1 Torr or less than 0.1 Torr, more preferably less than 50 mTorr, less than 40 mTorr, less than 30 mTorr, less than 20 mTorr or less than 10 mTorr, and most preferably less than 5 mTorr or less than 1 mTorr.

Preferably, the radio-frequency electrical power supply operates at a frequency between 1 and 50 MHz or between 5 and 25 MHz, and most preferably at a frequency between 7.5 and 20 MHz or between 10 and 15 MHz. In a preferred embodiment, the radio-frequency electrical power supply operates at a frequency of 13.56 MHz as this is an industrial, scientific and medical (ISM) radio band.

In embodiments where the component comprises an electrically insulating material, the electrical power supply is configured to generate an electrical field which is able to penetrate through the component and create a plasma. It may be appreciated that the electrical field is able to penetrate through the component due to the electrically insulating material being electrically coupled to the power supply by an alternating electromagnetic field. It may be appreciated that the strength of the electrical field required to penetrate through the component may depend upon the composition of the component and the thickness of the component. In some embodiments, the electrical power supply may be configured to apply electrical power to the platen at a power of between 0.001 Watts/cm² and 5 Watt/cm² or between 0.005Watts/cm² and 1 Watts/cm² and most preferably between 0.01 and 0.5 Watts/cm².

In embodiments where the component comprises an electrically conductive material, the electrical power supply is configured to apply electrical power to an electrically conductive component supported by the platen. Preferably, the electrical power supply is configured to apply electrical power to an electrically conductive component disposed supported by the platen at a power of between 0.001 Watts/cm² and 5 Watt/cm² or between 0.005Watts/cm² and 1 Watts/cm² and most preferably between 0.01 and 0.5 Watts/cm².

The apparatus may comprise an injection means, configured to inject a gas into the deposition chamber. The gas may be hydrogen, a hydrocarbon, an organometallic compound and/or a noble gas. The hydrocarbon may be acetylene. The organometallic compound may be titanium isopropoxide (TIPP). Alternatively, the organometallic compound may be a precursor of silicon, such as silane or tetraethyl orthosilicate (TEOS). The noble gas may be argon.

The first elevated temperature may vary depending upon which poly(p-xylylene) dimer the apparatus is configured to be used with. The required pyrolysis temperatures will be well known by the skilled person. For instance, the pyrolysis temperature for both Parylene N^{™} and Parylene C^{™} is 650°C, the pyrolysis temperature of Parylene HT^{™} is 700°C and the pyrolysis temperature of Parylene D^{™} is 750°C. The first elevated temperature may be at least 200°C, more preferably at least 300°C, at least 400°C or at least 500°C, and most preferably at least 600°C or at least 650°C. In some embodiments, the first elevated temperature may be at least 700°C, at least 750°C or at least 800°C. The first elevated temperature may be between 200°C and 1500°C, more preferably between 300°C and 1400°C, between 400°C and 1200°C or between 500°C and 1000°C, and most preferably between 600°C and 900°C or between 650°C and 800°C.

Advantageously, the pyrolysis oven is configured to cause the dimer to decompose to provide the monomer.

The first feed means may comprise a vacuum valve. It may be appreciated that a vacuum valve may otherwise be known as a trickle valve, and is used to maintain an airlock seal. Accordingly, the vacuum valve may be configured to reversibly create an airlock seal between the pyrolysis oven and the deposition chamber.

The poly(p-xylylene) dimer may be a molecule of formula (III): 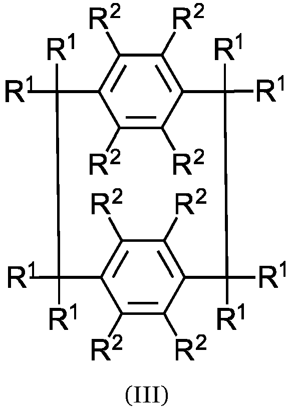 , wherein R¹ and R² are as defined above.

Accordingly, the poly(p-xylylene) dimer may be a molecule of formula (IIIa), (IIIb), (IIIc) or (IIId):

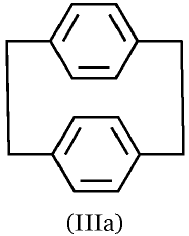

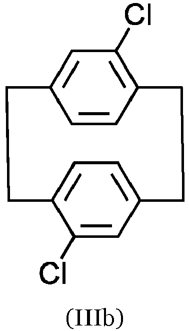

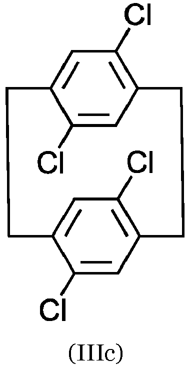

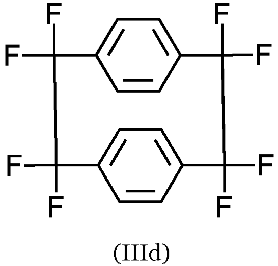

Accordingly, the second elevated temperature may vary depending upon which poly(p-xylylene) dimer the apparatus is configured to be used with. The required evaporation temperatures will be well known by the skilled person. For instance, the evaporation temperatures for both Parylene N^{™}, Parylene C^{™}, Parylene D^{™} and Parylene HT^{™} are all between 150°C and 300°C. The second elevated temperature may be at least 60°C, more preferably at least 80°C, at least 100°C or at least 500°C, and most preferably at least 120°C or at least 130°C. Preferably, the second heating element is configured to heat the vaporiser oven to a temperature between 60°C and 650°C. Preferably, the second heating element is configured to heat the vaporiser oven to a temperature of between 80°C and 500°C or between 100°C and 300°C, and most preferably between 120°C and 250°C or between 130°C and 200°C.

Advantageously, the vaporiser oven is configured to vaporise the dimer.

The apparatus may comprise control means.

The control means may be configured to activate the vacuum pump when a user initiates a first coating cycle.

The apparatus may comprise a pressure sensor. The pressure sensor may be disposed in the deposition chamber. The control means may be configured to monitor the pressure in the deposition chamber.

The control means may be configured to activate the first heating element when the pressure in the deposition chamber has fallen below a predetermined pressure. The predetermined pressure may be a pressure of less than 10 Torr, less than 1 Torr or less than 0.1 Torr, more preferably less than 50 mTorr, less than 40 mTorr, less than 30 mTorr, less than 20 mTorr or less than 10 mTorr, and most preferably less than 5 mTorr or less than 1 mTorr.

The apparatus may comprise a temperature sensor disposed in the pyrolysis oven. The control means may be configured to monitor the temperature in the pyrolysis oven. The control means may be configured to activate the second heating element when the temperature in the pyrolysis oven has risen above a predetermined temperature. The predetermined temperature may be a temperature of at least 200°C, more preferably at least 300°C, at least 400°C or at least 500°C, and most preferably at least 600°C or at least 650°C. In some embodiments, the predetermined temperature may be at least 700°C, at least 750°C or at least 800°C

The control means may be configured to maintain the pyrolysis oven within a predetermined temperature range. The predetermined temperature range is preferably between 200°C and 1500°C, more preferably between 300°C and 1400°C, between 400°C and 1200°C or between 500°C and 1000°C, and most preferably between 600°C and 900°C or between 650°C and 800°C.

The apparatus may comprise a temperature sensor disposed in the vaporiser oven. The control means may be configured to monitor the temperature in the vaporiser oven. The control means may be configured to maintain the vaporiser oven within a predetermined temperature range. The predetermined temperature range is preferably between 60°C and 650°C, more preferably between 80°C and 500°C, between 100°C and 300°C or between 500°C and 1000°C, and most preferably between 120°C and 250°C or between 130°C and 200°C.

The control means may be configured to activate the electrical power supply, after having activated the first and second heating elements and when the pressure in the deposition chamber has risen above a predetermined pressure. The predetermined pressure may be a pressure of at least 1 mTorr, more preferably at least 10 mTorr, at least 20 mTorr, at least 30 mTorr, at least 40 mTorr or at least 50 mTorr, and most preferably at least 0.1 Torr, at least 1 Torr or at least 10 Torr.

After activation of the electrical power supply, the control means may be configured to maintain the pressure in the deposition chamber below 100 Torr, more preferably below 50 Torr, below 25 Torr, below 20 Torr or below 15 Torr, and most preferably below 10 Torr, below 5 Torr, below 2 Torr or below 1 Torr.

The control means may be configured to activate the injection means, and thereby inject a gas into the deposition chamber, before or after activating the electrical power supply. In one embodiment, the activation means may activate the injection means before activating the electrical power supply. The control means may then deactivate the injection means after the electrical power supply. Accordingly, the gas will form an additive which is disposed throughout the coating to add functionality.

In an alternative embodiment, the activate the injection means before, or a predetermined time after, activating the electrical power supply. The control means may then deactivate the injection means a predetermined time after it has been activated. In this embodiment, the electrical power supply may be activated for a period when the injection means is not activated. Accordingly, the gas is injected at selected times to produce a multi-layer coating.

The apparatus may comprise a monitor configured to monitor the thickness of a layer deposited on the component. The monitor may comprise a crystal film thickness monitor.

The control means may be configured to finish a cycle a predetermined time after the electrical power supply, when the layer deposited on the component has reached a desired thickness and/or when it receives an input from a user.

It may be appreciated that the predetermined time will vary depending upon a number of facts including the geometry of the component being coated and the desired thickness of the deposited layer. Accordingly, it may be appreciated that the predetermined time may be determined by the skilled person. In one embodiment, the predetermined time may be at least 5 minutes, more preferably at least 30 minutes, at least 1 hour or at least 1.5 hours, and most preferably at least 2 hours. In one embodiment, the predetermined time may be less than 12 hours, more preferably less than 6 hours, less than 5 hours or less than 4 hours, and most preferably less than 3 hours. In one embodiment, the predetermined time may be between 5 minutes and 12 hours, more preferably between 30 minutes and 6 hours, between 1 hour and 5 hours or between 1.5 hours and 4 hours, and most preferably between 2 and 3 hours.

It may be appreciated that the desired thickness of the deposited layer will vary depending upon the component. If the component comprises a smooth surface, the deposition layer will preferably be at least 50 nm may be applied. Accordingly, in some embodiments, a deposition layer of between 50 nm and 1 µm may be applied. In some embodiments, a thicker deposition layer may be desirable. Accordingly, the deposition layer may be at least 1 µm, and may be between 50 µm and 100 µm. Alternatively, if the component comprises a rough surface, then it may be desirable for the thickness of the deposition layer to be thicker than the depth of the roughness of the surface of the component.

The control means may finish a cycle by closing the vacuum valve. It may be appreciated that closing the vacuum valve creates an airlock seal between the deposition chamber and the pyrolysis oven.

The control means may be configured to deactivate the electrical power supply. The electrical power supply may be deactivated prior to, at the same to as or after the control means has closed the vacuum valve.

The control means may be configured to vent the apparatus after it has deactivated the power supply and closed the vacuum valve. Preferably, venting the apparatus comprises raising the pressure in the deposition chamber to about atmospheric pressure. Advantageously, a user can then remove the component from the deposition chamber and place a further to be coated component therein.

In embodiments where the injection means is activated, the control means may be configured to deactivate the injection means after deactivating the electrical power supply and prior to venting the apparatus.

The control means may be configured to activate the vacuum pump when a user initiates a further coating cycle.

The control means may be configured to open the vacuum valve when the pressure in the deposition chamber has fallen below a predetermined pressure. The predetermined pressure may be a pressure of less than 10 Torr, less than 1 Torr or less than 0.1 Torr, more preferably less than 50 mTorr, less than 40 mTorr, less than 30 mTorr, less than 20 mTorr or less than 10 mTorr, and most preferably less than 5 mTorr or less than 1 mTorr.

The control means may be configured to activate the electrical power supply, after having opened the vacuum valve when the pressure in the deposition chamber has risen above a predetermined pressure. The predetermined pressure may be a pressure of at least 1 mTorr, more preferably at least 10 mTorr, at least 20 mTorr, at least 30 mTorr, at least 40 mTorr or at least 50 mTorr, and most preferably at least 0.1 Torr, at least 1 Torr or at least 10 Torr.

The control means may be configured to power down the apparatus. The control means may power down the apparatus after a predetermined number of cycles have been run and/or when it receives an input from a user. The apparatus may power down the apparatus instead of finishing a cycle. Accordingly, if the apparatus is only configured to run one cycle, the control means may power down the apparatus a predetermined time after the electrical power supply, when the layer deposited on the component has reached a desired thickness and/or when it receives an input from a user.

The control means may power down the apparatus by deactivating the electrical power supply.

The control means may be configured to deactivate the first and second heating elements after deactivating the electrical power supply. The control means may be configured to deactivate the vacuum pump when the temperature in the vaporiser oven and/or in the pyrolysis oven falls below a predetermined temperature. The predetermined temperature may be less than 100°C, more preferably the predetermined temperature is less than 80°C or less than 60°C, and most preferably is less than 50°C.

In embodiments where the injection means is activated, the control means may be configured to deactivate the injection means after deactivating the electrical power supply and prior to venting the apparatus.

The control means may be configured to vent the apparatus. Preferably, venting the apparatus comprises raising the pressure in the deposition chamber to about atmospheric pressure. In embodiments where they are present, venting the apparatus may comprise raising the pressure in the vaporiser oven and/or in the pyrolysis oven to about atmospheric pressure. The control means may be configured to vent the apparatus at the same time or after deactivating the vacuum pump.

The vacuum valve may be left open while the control means is powering down the apparatus.

In accordance with a second aspect of the invention, there is provided a method for depositing poly(p-xylylene) on a component, according to claim 9, the method comprising:
- supporting the component on a platen in a deposition chamber, wherein the platen comprises an electrically conductive material, is connected to an electrical power supply and is electrically insulated from an electrode;
- feeding a poly(p-xylylene) monomer to the component;
- activating the electrical power supply and thereby creating a plasma that surrounds the component and ionises and/or activates the poly(p-xylylene) monomer; and
- allowing the ionised and/or activated poly(p-xylylene) monomer to deposit on the component and polymerise, and thereby form poly(p-xylylene) on the component,
wherein (i) the component comprises an electrically conductive material and the electrical power supply applies electrical power to the electrically conductive component at a power of between 0.0001 Watts/cm² and 10 Watt/cm²; or wherein (ii) the platen comprises a plate configured to receive the component thereon and the component consists of an electrically insulating material and the electrical power supply generates an electrical field able to penetrate through the component to create the plasma by applying electrical power to the platen at a power of between 0.0001 Watts/cm² and 10 Watt/cm².

The component, electrode, poly(p-xylylene) monomer and electrical power supply may be as defined in relation to the first aspect.

Preferably, the method is a method of depositing a poly(p-xylylene) film on the component.

In embodiments where the component comprises an electrically insulating material it may be appreciated that the poly(p-xylylene) monomer may only deposit on one side thereof. Accordingly, subsequent to the steps recited above, the method may further comprise:
- repositioning the component on the platen to expose an uncoated side thereof;
- feeding a poly(p-xylylene) monomer to the component;
- activating the electrical power supply and thereby creating a plasma that surrounds the component and ionises and/or activates the poly(p-xylylene) monomer; and
- allowing the ionised and/or activated poly(p-xylylene) monomer to deposit on the uncoated side of the component and polymerise, and thereby form poly(p-xylylene) on the component.

The deposition chamber may be as defined in relation to the first aspect. Feeding a poly(p-xylylene) monomer to the component may comprise feeding the poly(p-xylylene) monomer into the deposition chamber.

Activating the electrical power supply may comprise applying an electrical power to the electrically conductive component and/or the platen of between 0.001 Watts/cm² and 5 Watt/cm² or between 0.005Watts/cm² and 1 Watts/cm² and most preferably between 0.01 and 0.5 Watts/cm².

Prior to feeding the poly(p-xylylene) monomer into the deposition chamber, the method may comprise reducing the pressure in the deposition chamber. The method may comprise reducing the pressure to less than 10 Torr, less than 1 mTorr or less than 0.1 mTorr, more preferably less than 50 mTorr, less than 40 mTorr, less than 30 mTorr, less than 20 mTorr or less than 10 mTorr, and most preferably less than 5 mTorr or less than 1 mTorr.

Prior to feeding the poly(p-xylylene) monomer into the deposition chamber, the method may comprise decomposing a poly(p-xylylene) dimer to obtain the poly(p-xylylene) monomer. The method may comprise heating the poly(p-xylylene) dimer to a temperature of at least 200°C, more preferably at least 300°, at least 400°C or at least 500°C, and most preferably at least 600°C or at least 650°C to cause the poly(p-xylylene) dimer to decompose. The method may comprise heating the poly(p-xylylene) dimer to a temperature between 200°C and 1500°C, more preferably between 300°C and 1400°C, between 400°C and 1200°C or between 500°C and 1000°C, and most preferably between 600°C and 900°C or between 650°C and 800°C to cause the poly(p-xylylene) dimer to decompose.

Prior to decomposing a poly(p-xylylene) dimer, the method may comprise evaporating the poly(p-xylylene) dimer. The method may comprise heating the poly(p-xylylene) dimer to a temperature of at least 60°C, more preferably at least 80°C, at least 100°C or at least 500°C, and most preferably at least 120°C or at least 130°C to cause the poly(p-xylylene) dimer to evaporate. The method may comprise heating the poly(p-xylylene) dimer to a temperature between 60°C and 650°C, more preferably between 80°C and 500°C, between 100°C and 300°C or between 500°C and 1000°C, and most preferably between 120°C and 250°C or between 130°C and 200°C to cause the poly(p-xylylene) dimer to evaporate.

The method may comprise feeding a gas into the deposition chamber. The gas may be as defined in relation the first aspect. In one embodiment, the method comprises feeding the gas into the deposition chamber for the entire time that the electrical power supply is activated. In an alternative embodiment, the method comprises feeding the gas into the chamber for discrete intervals while the electrical power supply is activated.

The method may comprise deactivating the electrical power supply. The electrical power supply may be deactivated a predetermined time after it has been activated or when a layer deposited on the component has reached a desired thickness.

The method may comprise venting the deposition chamber. The deposition chamber may be vented after the electrical power supply has been deactivated. Venting the deposition chamber may comprise raising the pressure therein to atmospheric pressure.

The method may comprise closing a vacuum valve to isolate the deposition chamber. The vacuum valve may be closed prior to, at the same time as or after the electrical power supply is deactivated. The vacuum valve may be closed before the deposition chamber is vented.

In embodiments where the method does not comprise closing a vacuum valve, the method may comprise allowing a pyrolysis oven and/or a vaporiser oven to cool to a predetermined temperature. The predetermined temperature may be less than 100°C, more preferably the predetermined temperature is less than 80°C or less than 60°C, and most preferably is less than 50°C.

All features described herein (including any accompanying claims, abstract and drawings), and/or all of the steps of any method or process so disclosed, may be combined with any of the above aspects in any combination, except combinations where at least some of such features and/or steps are mutually exclusive.

For a better understanding of the invention, and to show how embodiments of the same may be carried into effect, reference will now be made, by way of example, to the accompanying drawings, in which:-
**Figure 1** is a schematic diagram of an apparatus for depositing a film of poly(p-xylylene) polymer on a component;
**Figure 2** shows a platen configured to support the component;
**Figure 3** is a scanning electron microscope (SEM) image of a film of poly(p-xylylene) polymer deposited on a substrate using a prior art method;
**Figure 4** is an SEM image of a film of poly(p-xylylene) polymer deposited on a substrate using the method in accordance with the present invention; and
**Figure 5** is a schematic diagram of an alternative apparatus for depositing a film of poly(p-xylylene) polymer on a component.

### Example 1

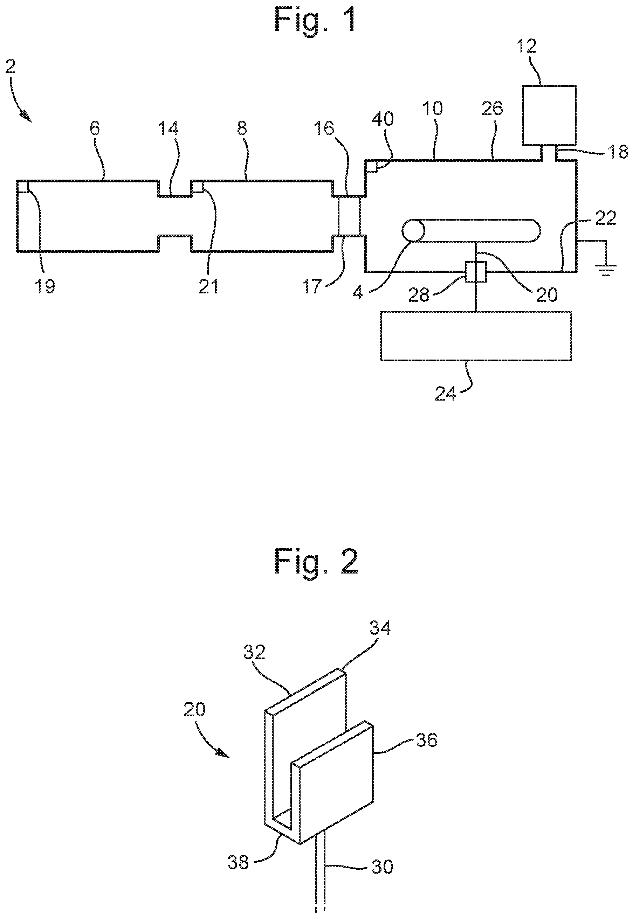

Figure 1 shows an apparatus 2 configured to deposit a film of poly(p-xylylene) polymer on an electrically conductive component 4. The apparatus comprises a vaporiser oven 6, a pyrolysis oven 8, a deposition chamber 10 and a vacuum pump 12. A first conduit 14 extends between the vaporiser oven 6 and the pyrolysis oven 8, a second conduit 16 extends between the pyrolysis oven 8 and the deposition chamber 10 and a third conduit 18 extends between the deposition chamber 10 and the vacuum pump 12. A vacuum valve 17 is disposed in the second conduit 16.

The vaporiser oven 6 comprises a first heating element (not shown) configured to heat the vaporiser oven 6 to a temperature between 130°C and 200°C and a first temperature sensor 19 configured to sense the temperature therein. Similarly, the pyrolysis oven 8 comprises a second heating element (not shown) configured to heat the pyrolysis oven 8 to a temperature between 650°C and 800°C and a second temperature sensor 21 configured to sense the temperature therein.

The deposition chamber 10 comprises a metallic housing 26. As shown in Figure 1, the metallic housing 26 is earthed

As shown in Figure 1, an electrically conductive component 4 may be disposed in the deposition chamber 10. The component 4 is disposed on a platen 20, which holds the component 4 above the base 22 of the deposition chamber 10 and electrically connects the component 4 to a radio-frequency electrical power supply 24. The radio-frequency power supply 24 used by the inventors operated at a frequency of 13.56 MHz, as this is an industrial, scientific and medical (ISM) radio band, and so will not disrupt radio communication. The component 4 is electrically insulated from the metallic housing 26 due to an insulating material 28 being disposed between the platen 20 and the housing 26.

As shown in Figure 2, the platen 20 may comprise a metallic rod 30 with a resilient metallic clip 32 disposed thereon. The metallic clip 32 comprises spaced apart flanges 34, 36 joined by a connecting portion 38. A portion of component 4 can slot between the flanges 34, 36, and the platen 20 is thereby able to support the component 4. The metallic clip 32 is sized so as to contact as little of the component 4 as possible, and typically contacts less than 1% of the surface of the component.

To coat a component 4 with a film of poly(p-xylylene) polymer, a user first loads a poly(p-xylylene) dimer into the vaporiser oven 6. The quantity the user loads depends upon the size of the component 4 to be coated. The inventors have typically used between 1 to 20 grams, and have found that this is sufficient to coat a component 4 with complex three dimensional geometry and a maximum dimension of between about 10 and 20 cm mark, or a flat component 4 with a maximum dimension of about 50 cm. It will be appreciated that these are examples only, and the method described herein could be used to apply a poly(p-xylylene) coating to a component of any size.

The user also loads the component 4 into the deposition chamber 10 and positions it on the platen 20 to connect it electrically to the radio-frequency electrical power supply 24.

The user can also place a small amount of an adhesion promotion agent, such as A-174, in the deposition chamber 10. The adhesion promotion agent can be provided in an open container, such as a petri dish. The amount of adhesion promotion agent required would depend upon the size of the component 4, but the inventors have typically used about 3 ml. It should be noted, that the use of a plasma, as described below, enhances the reactivity of the monomers and activates the surface of the component 4. Accordingly, the adhesion of the poly(p-xylylene) polymer is stronger than was possible previously. Accordingly, the adhesion agent may not be required.

The user then hermetically seals the apparatus 2, ensures that the vacuum valve 16 is open and then activates the vacuum pump 12 to cause the pressure within the vaporiser oven 6, pyrolysis oven 8 and deposition chamber 10 to reduce to lower than 10⁻³ Torr. This causes the adhesion agent, if present, to evaporate and coat the inside of the deposition chamber 10 and component 4.

The user then activates the second heating element to heat the pyrolysis oven 8 to a temperature between 650°C and 800°C. Once the pyrolysis oven 8 has reached the desired temperature, the user activates the first heating element to heat the vaporiser oven 6 to a temperature between 130°C and 200°C. As the temperature in the vaporiser oven 6 rises the poly(p-xylylene) dimer disposed therein evaporates. Due to the vacuum, the parylene dimer flows into the pyrolysis oven 8, and the high temperature therein causes the dimer to decompose into two monomer molecules. The monomer molecules continue to flow into the deposition chamber 10, raising the pressure therein.

When a pressure sensor 40 disposed in the deposition chamber 10 records that the pressure has reached 50mTorr, the user turns-on the radio-frequency electrical power supply 24. The electrical power delivered by the radio-frequency electrical power supply 24 is typically 0.1 Watts/cm². Due to the metallic housing 26 of the deposition chamber 10 being grounded, it acts as a virtual electrode a plasma is created around the component 4. The plasma ionises and/or activates the monomers, typically causing them to become positively charged. The plasma activates the surface of the component 4. The ionised monomers are attracted to the component 4, deposit thereon and polymerise to form a poly(p-xylylene) polymer coating.

During deposition, other gases can be added to the deposition chamber by injection. These gases could include a hydrocarbon, such as acetylene, and/or an organometallic compound, such as tetraethyl orthosilicate (TEOS), and/or titanium isopropoxide (TIPP). The additives can be present in the deposition chamber 10 throughout the deposition process so they are disposed throughout the coating to add functionality. Alternatively, they may be added at selected times to produce a multi-layer coating.

Once the desired coating thickness has been reached, as determined by a crystal film thickness monitor (not shown) disposed in the deposition chamber 10, the user can stop the process. The user can first turn-off the radio-frequency electrical power supply 24 and then turn-off both heating elements. When the vaporiser oven 6 and pyrolysis oven 8 have both cooled to a temperature below 50°C, the user stops the vacuum pump 12 and vents the deposition chamber 10 to ambient pressure. The user can then open the deposition chamber 10 and retrieve the coated component 4.

The ovens 6, 8 take a long time to cool. Accordingly, if the user would like to use the apparatus to apply a coating to a further component 4 they may not want to wait for the ovens 6, 8 to cool. In this scenario, the user can close the vacuum valve 17 to isolate the ovens 6, 8. The user then stops the vacuum pump 12 and vents the deposition chamber 10 to ambient pressure. The user can then open the deposition chamber 10 and retrieve the coated component 4, replacing it with a further component 4 to be coated.

### Example 2

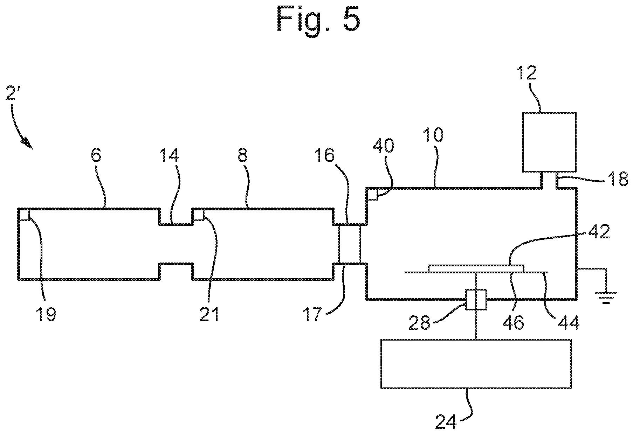

Figure 5 shows an alternative apparatus 2' configured to deposit a film of poly(p-xylylene) polymer on a component 42 comprising an electrically insulating material. As shown in the Figure, the component 42 has a thin width and is flat. The exact thickness of the component 42 will vary. For instance, it is noted that the inventors have successfully used this method to coat components thicknesses between 2 and 3 cm. It will be appreciated that thicker components could be coated if a stronger electrical field is used.

Similarly to the apparatus 2 described in example 1, the apparatus 2' comprises a vaporiser oven 6, a pyrolysis oven 8, a deposition chamber 10 and a vacuum pump 12 interconnected by conduits 14, 16, 18, which are as described in example 1.

As shown in Figure 5, the deposition chamber comprises a platen 44 which defines a flat platform configured to receive the component 42 thereon. The platen 44 is electrically connected to a radio-frequency electrical power supply 24, which is as defined in example 1. The platen 44 is electrically insulated from the metallic housing 26 due to an insulating material 28 being disposed between the platen 20 and the housing 26.

To coat a component 42 with a film of poly(p-xylylene) polymer, a user follows the method described in the first example.

Once the desired coating thickness has been reached, the user can close the vacuum valve 17 to isolate the ovens 6, 8. The user then stops the vacuum pump 12 and vents the deposition chamber 10 to ambient pressure. The user can then open the deposition chamber 10 and reposition the component 42, so that the uncoated underside 46 thereof is exposed. The user can then repeat the coating method described in the first aspect.

Alternatively, the apparatus 2' may comprise rotation equipment configured to rotate the component. Accordingly, once the desired coating thickness has been reached, the rotation equipment could rotate the component without the need to break the vacuum and without any input from the user.

The user can then deactivate the apparatus 2' or use it to coat further components, as described in the first example.

### Conclusion

Due to the monomers being attracted to the component 4, the deposition rate for an electrically conductive component is significantly enhanced. In particular, the inventors have found that the above method can provide a uniform coating on components with complex geometries. Additionally, due to the 20 holding the component 4 above the base 22 of the deposition chamber 10, the component may be coated on all sides in one cycle.

Furthermore, the amount of monomers which deposit on the walls of the deposition chamber 10 is significantly reduced. This means that the amount the dimer required is reduced. The extent to which a reduction is observed depends upon the geometry of the component. The inventors have observed that for some geometries a tenth of the amount of the dimer is required compared to prior art processes. Furthermore, due to the lower deposition rate on the walls of the deposition chamber, the amount of cleaning required between cycles is reduced, thereby reducing down-time for the apparatus 2.

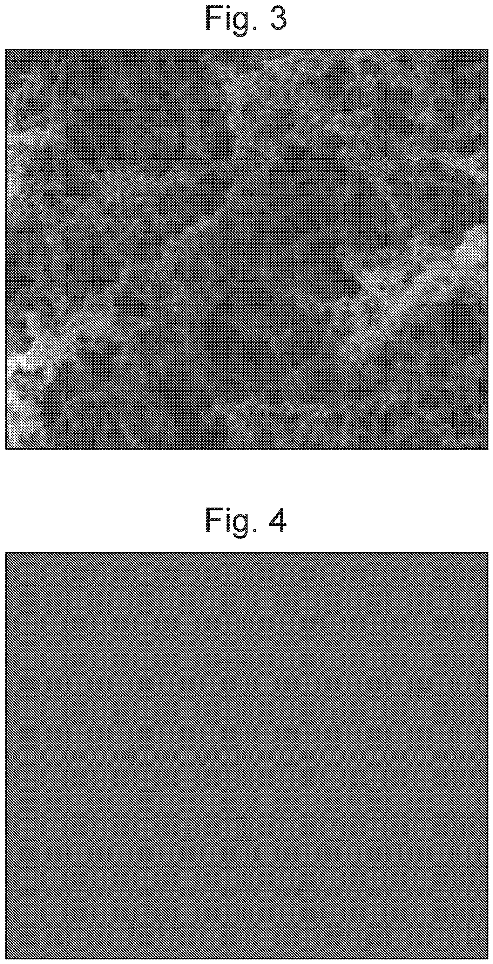

In addition, the inventors have observed that the plasma reduces the amount of dust formation in the chamber. A film of poly(p-xylylene) polymer deposited on a substrate using the method described above is shown in Figure 4. It will be noted that due to the lack of dust formation, the poly(p-xylylene) polymer shown in Figure 4 defines a smooth surface.

In prior art methods, dust is formed by poly(p-xylylene) monomer molecules binding to each-other prematurely in the vapour phase, as a result of collisions between molecules, instead of binding after deposition on a surface. Dust formation is typically prominent when a carrier gas is used (for example argon) for purposes of enhancing the uniformity of the poly(p-xylylene) coating. An image of a film of poly(p-xylylene) polymer deposited on a substrate using a prior art method which resulted in dust formation is shown in Figure 3. It will be noted that due to the dust formation, the poly(p-xylylene) polymer shown in Figure 3 defines a rough surface. It also does not adhere as well to the substrate as the poly(p-xylylene) polymer layer shown in Figure 4.

Accordingly, the present invention allows the use of carrier gases while minimising dust formation.

## Claims

1. An apparatus (2) for depositing poly(p-xylylene) onto a component (4), the apparatus (2) comprising:
- a radio-frequency electrical power supply (24) configured to operate at a frequency between 1 and 100 MHz;
- a deposition chamber (10);
- a platen (20) disposed inside the deposition chamber (10) and comprising an electrically conductive material, wherein the platen (20) is electrically connected to the electrical power supply (24) and configured to support a component (4);
- an electrode, either disposed in the deposition chamber (10) or defined by the deposition chamber (10) wherein the electrode is electrically insulated from the platen (20);
- a pyrolysis oven (8), comprising a first heating element configured to heat the pyrolysis oven (8) to a first elevated temperature sufficient to cause pyrolysis of a poly(p-xylylene) dimer;
- a vaporiser oven (6), comprising a second heating element configured to heat the vaporiser oven (6) to a second elevated temperature sufficient to cause evaporation of the poly(p-xylylene) dimer;
- a first feed means (16) comprising a conduit which extends between the pyrolysis oven (8) and the deposition chamber (10) and being configured to feed a poly(p-xylylene) monomer to the platen (20); and
- a second feed means (14) comprising a conduit which extends between the vaporiser oven (6) and the pyrolysis oven (8) and being configured to feed the poly(p-xylylene) dimer into the pyrolysis oven (8),
wherein (i) the platen (20) is configured to support a component (4) comprising an electrically conductive material and the electrical power supply (24) is configured to apply electrical power to the electrically conductive component (4) supported by the platen (20) at a power of between 0.0001 Watts/cm² and 10 Watt/cm² such that a plasma is generated that surrounds the component and ionizes and/or activates the poly(p-xylylene) monomer; or wherein (ii) the platen (20) is configured to support a component (4) consisting of an electrically insulating material and the platen (20) comprises a plate configured to receive the component (4) thereon and the electrical power supply (24) is configured to apply electrical power to the platen (20) at a power of between 0.0001 Watts/cm² and 10 Watt/cm² such that an electrical field is generated, which is able to penetrate through the component (4) and to create a plasma that surrounds the component and ionizes and/or activates the poly(p-xylylene) monomer.

2. An apparatus (2) according to claim 1, wherein the component (4) comprises an electrically conductive material, and the platen (20) comprises a resilient clip configured to receive a portion of the electrically conductive component.

3. An apparatus (2) according to claim 1, wherein the component (4) consists of an electrically insulating material and has a substantially flat surface and the platen (20) comprises a substantially flat plate configured to receive the component thereon.

4. An apparatus (2) according to claim 3, wherein the component (4) consists of an electrically insulating material and has a thickness of less than 25 cm, less than 10cm, less than 7.5 cm, less than 5 cm, less than 3 cm, less than 2 cm or less than 1 cm.

5. An apparatus (2) according to any preceding claim, wherein the first feed means (16) comprises a vacuum valve.

6. An apparatus (2) according to any preceding claim, wherein the deposition chamber (10) comprises an earthed conductive housing which defines the electrode; and/or the apparatus (2) comprises an injection means, configured to inject a gas into the deposition chamber (10).

7. An apparatus (2) according to any preceding claim, wherein the apparatus (2) further comprises:
- a pressure sensor disposed in the deposition chamber (10);
- a temperature sensor disposed in the pyrolysis oven (8);
- a vacuum pump (12) configured to reduce the pressure of the deposition chamber (10) to a pressure of less than 10 Torr; and
- control means configured to:
o activate the vacuum pump (12) when a user initiates a first coating cycle;
o activate the first heating element when the pressure in the deposition chamber (10) has fallen below a first predetermined pressure;
o activate the second heating element when the temperature in the pyrolysis oven (8) has risen above a predetermined temperature; and
∘ activate the electrical power supply (24), after having activated the first and second heating elements and when the pressure in the deposition chamber (10) has risen above a second predetermined pressure.

8. An apparatus (2) according to any preceding claim, wherein the first elevated temperature is between 200°C and 1500°C, and/or the second elevated temperature is between 80°C and 500°C.

9. A method for depositing poly(p-xylylene) on a component (4), the method comprising:
- supporting the component (4) on a platen (20) in a deposition chamber (10), wherein the platen (2) comprises an electrically conductive material, is connected to a radio-frequency electrical power supply (24) configured to operate at a frequency between 1 and 100 MHz and is electrically insulated from an electrode;
- feeding a poly(p-xylylene) monomer to the component (4);
- activating the electrical power supply (24) and thereby creating a plasma that surrounds the component (4) and ionises and/or activates the poly(p-xylylene) monomer; and
- allowing the ionised and/or activated poly(p-xylylene) monomer to deposit on the component (4) and polymerise, and thereby form poly(p-xylylene) on the component (4),
wherein (i) the component (4) comprises an electrically conductive material and the electrical power supply (24) applies electrical power to the electrically conductive component (4) at a power of between 0.0001 Watts/cm² and 10 Watt/cm²; or wherein (ii) the platen (20) comprises a plate configured to receive the component (4) thereon and the component (4) consists of an electrically insulating material and the electrical power supply (24) applies electrical power to the platen (20) at a power of between 0.0001 Watts/cm² and 10 Watt/cm² such that an electrical field is generated, which is able to penetrate through the component (4) and to create the plasma.

10. A method according to claim 9, wherein feeding the poly(p-xylylene) monomer to the component (4) comprises feeding the poly(p-xylylene) monomer into the deposition chamber (10), thereby causing the pressure in the deposition chamber (10) to rise, and the method comprises activating the electrical power supply (24) after the pressure in the deposition chamber (10) reaches a predetermined pressure.

11. A method according to claim 10, wherein prior to feeding the poly(p-xylylene) monomer into the deposition chamber (10), the method comprises reducing the pressure in the deposition chamber (10) to less than 10 Torr.

12. A method according to any one of claims 9 to 11, wherein the method comprises deactivating the electrical power supply (24) a predetermined time after it has been activated or when a layer deposited on the component (4) has reached a desired thickness.

13. A method according to claim 12, wherein the method comprises venting the deposition chamber (10) after the electrical power supply (24) has been deactivated.

## Patentansprüche

1. Vorrichtung (2) zum Auftragen von Poly(p-xylylen) auf ein Bauteil (4), wobei die Vorrichtung (2) umfasst:
- eine elektrische Hochfrequenz-Stromversorgung (24), eingerichtet für das Betreiben mit einer Frequenz zwischen 1 und 100 MHz;
- eine Auftragungskammer (10);
- eine Platte (20), die innerhalb der Auftragungskammer (10) angeordnet ist und ein elektrisch leitfähiges Material umfasst, wobei die Platte (20) elektrisch mit der Stromversorgung (24) verbunden und so eingerichtet ist, dass sie ein Bauteil (4) trägt,
- eine Elektrode, die entweder in der Auftragungskammer (10) angeordnet ist oder durch die Auftragungskammer (10) abgegrenzt ist, wobei die Elektrode von der Platte (20) elektrisch isoliert ist;
- einen Pyrolyseofen (8), der ein erstes Heizelement umfasst, das so eingerichtet ist, dass es den Pyrolyseofen (8) auf eine erste erhöhte Temperatur erwärmt, die ausreicht, die Pyrolyse eines Poly(p-xylylen)-Dimers zu bewirken;
- einen Verdampferofen (6), der ein zweites Heizelement umfasst, das so eingerichtet ist, dass es den Verdampferofen (6) auf eine zweite erhöhte Temperatur erwärmt, die ausreicht, die Verdampfung des Poly(p-xylylen)-Dimers zu bewirken;
- ein erstes Zuführmittel (16), das eine Rohrleitung umfasst, die sich zwischen dem Pyrolyseofen (8) und der Auftragungskammer (10) erstreckt und so eingerichtet ist, dass sie der Platte (20) ein Poly(p-xylylen)-Monomer zuführt, und
- ein zweites Zuführmittel (14), das eine Rohrleitung umfasst, die sich zwischen dem Verdampferofen (6) und dem Pyrolyseofen (8) erstreckt und so eingerichtet ist, dass sie das Poly(p-xylylen)-Dimer dem Pyrolyseofen (8) zuführt,
wobei
(i) die Platte (20) so eingerichtet ist, dass sie ein Bauteil (4) trägt, das ein elektrisch leitfähiges Material umfasst, und die Stromversorgung (24) so eingerichtet ist, dass sie elektrische Energie an das von der Platte (20) getragene elektrisch leitfähige Bauteil (4) mit einer Leistung zwischen 0,0001 Watt/cm² und 10 Watt/cm² anlegt, so dass ein Plasma erzeugt wird, welches das Bauteil umgibt und das Poly(p-xylylen)-Monomer ionisiert und/oder aktiviert;
oder, wobei (ii) die Platte (20) so eingerichtet ist, dass sie ein Bauteil (4) trägt, das aus einem elektrisch isolierenden Material besteht, und die Platte (20) einen Boden umfasst, der so eingerichtet ist, dass er das Bauteil (4) darauf aufnimmt, und die Stromversorgung (24) so eingerichtet ist, dass sie elektrische Energie an die Platte (20) mit einer Leistung zwischen 0,0001 Watt/cm² und 10 Watt/cm² anlegt, so dass ein elektrisches Feld erzeugt wird, das in der Lage ist, das Bauteil (4) zu durchdringen und ein Plasma zu erzeugen, welches das Bauteil umgibt und das Poly(p-xylylen)-Monomer ionisiert und/oder aktiviert.

2. Vorrichtung (2) nach Anspruch 1, wobei das Bauteil (4) ein elektrisch leitendes Material umfasst und die Platte (20) eine elastische Klammer umfasst, die so eingerichtet ist, dass sie einen Teil des elektrisch leitenden Bauteils aufnimmt.

3. Vorrichtung (2) nach Anspruch 1, wobei das Bauteil (4) aus einem elektrisch isolierenden Material besteht und eine im Wesentlichen flache Oberfläche aufweist und die Platte (20) einen im Wesentlichen flachen Boden umfasst, der so eingerichtet ist, dass er das Bauteil darauf aufnimmt.

4. Vorrichtung (2) nach Anspruch 3, wobei das Bauteil (4) aus einem elektrisch isolierenden Material besteht und eine Dicke von weniger als 25 cm, weniger als 10 cm, weniger als 7,5 cm, weniger als 5 cm, weniger als 3 cm, weniger als 2 cm oder weniger als 1 cm aufweist.

5. Vorrichtung (2) nach einem der vorhergehenden Ansprüche, wobei das erste Zuführmittel (16) ein Vakuumventil umfasst.

6. Vorrichtung (2) nach einem der vorhergehenden Ansprüche, wobei die Auftragungskammer (10) ein geerdetes, leitfähiges Gehäuse umfasst, das die Elektrode abgrenzt, und/oder die Vorrichtung (2) Einspritzmittel umfasst, die zum Einspritzen eines Gases in die Auftragungskammer (10) eingerichtet sind.

7. Vorrichtung (2) nach einem der vorhergehenden Ansprüche, wobei die Vorrichtung (2) ferner umfasst:
- einen in der Auftragungskammer (10) angeordneten Druckfühler;
- einen im Pyrolyseofen (8) angeordneten Temperaturfühler;
- eine Vakuumpumpe (12), die so eingerichtet ist, dass sie den Druck in der Auftragungskammer (10) auf einen Druck von weniger als 10 Torr reduziert, und
- Steuerungsmittel, die so eingerichtet sind, dass sie:
o die Vakuumpumpe (12) aktivieren, wenn ein Benutzer einen ersten Beschichtungszyklus einleitet;
o das erste Heizelement aktivieren, sobald der Druck in der Auftragungskammer (10) unter einen ersten vorgegebenen Druck gefallen ist;
∘ das zweite Heizelement aktivieren, sobald die Temperatur im Pyrolyseofen (8) über eine vorgegebene Temperatur angestiegen ist, und
∘ die elektrische Stromversorgung (24) aktivieren, nachdem sie das erste und das zweite Heizelement aktiviert haben und der Druck in der Auftragungskammer (10) über einen zweiten vorgegebenen Druck gestiegen ist.

8. Vorrichtung (2) nach einem der vorhergehenden Ansprüche, wobei die erste erhöhte Temperatur zwischen 200 °C und 1500 °C liegt und/oder die zweite erhöhte Temperatur zwischen 80 °C und 500 °C liegt.

9. Verfahren zum Auftragen von Poly(p-xylylen) auf ein Bauteil (4), wobei das Verfahren umfasst:
- Stützen des Bauteils (4) auf einer Platte (20) in einer Auftragungskammer (10), wobei die Platte (2) ein elektrisch leitfähiges Material umfasst, mit einer elektrischen Hochfrequenz-Stromversorgung (24), eingerichtet für das Betreiben mit einer Frequenz zwischen 1 und 100 MHz, verbunden ist, und die von einer Elektrode elektrisch isoliert ist;
- Zuführen eines Poly(p-xylylen)-Monomers zu dem Bauteil (4);
- Aktivieren der Stromversorgung (24) und dadurch Erzeugen eines Plasmas, welches das Bauteil (4) umgibt und das Poly(p-xylylen)-Monomer ionisiert und/oder aktiviert, und
- Zulassen, dass sich das ionisierte und/oder aktivierte Poly(p-xylylen)-Monomer auf dem Bauteil (4) ablagert und polymerisiert und sich dadurch Poly(p-xylylen) auf dem Bauteil (4) bildet, wobei
(i) das Bauteil (4) aus einem elektrisch leitfähigen Material besteht und die Stromversorgung (24) elektrische Energie an das elektrisch leitfähige Bauteil (4) mit einer Leistung zwischen 0,0001 Watt/cm² und 10 Watt/cm² anlegt, oder wobei (ii) die Platte (20) einen zum Aufnehmen des Bauteils (4) eingerichteten Boden aufweist und das Bauteil (4) aus einem elektrisch isolierenden Material besteht und die Stromversorgung (24) an die Platte (20) elektrische Energie mit einer Leistung zwischen 0,0001 Watt/cm² und 10 Watt/cm² anlegt, so dass ein elektrisches Feld erzeugt wird, das in der Lage ist, das Bauteil (4) zu durchdringen und das Plasma zu erzeugen.

10. Verfahren nach Anspruch 9, wobei das Zuführen des Poly(p-xylylen)-Monomers zu dem Bauteil (4) das Zuführen des Poly(p-xylylen)-Monomers in die Auftragungskammer (10) umfasst, wodurch ein Ansteigen des Drucks in der Auftragungskammer (10) bewirkt wird, und das Verfahren das Aktivieren der Stromversorgung (24) umfasst, nachdem der Druck in der Auftragungskammer (10) einen vorgegebenen Druck erreicht hat.

11. Verfahren nach Anspruch 10, wobei das Verfahren vor dem Zuführen des Poly(p-xylylen)-Monomers in die Auftragungskammer (10) das Verringern des Drucks in der Auftragungskammer (10) auf weniger als 10 Torr umfasst.

12. Verfahren nach einem der Ansprüche 9 bis 11, wobei das Verfahren das Deaktivieren der Stromversorgung (24) eine vorgegebene Zeit, nachdem sie aktiviert wurde, oder sobald eine auf dem Bauteil (4) abgeschiedene Schicht eine gewünschte Dicke erreicht hat, umfasst.

13. Verfahren nach Anspruch 12, wobei das Verfahren das Entlüften der Auftragungskammer (10) nach dem Deaktivieren der Stromversorgung (24) umfasst.

## Revendications

1. Appareil (2) pour déposer du poly(p-xylylène) sur un composant (4), l'appareil (2) comprenant :
- une alimentation électrique radiofréquence (24) configurée pour fonctionner à une fréquence comprise entre 1 et 100 MHz ;
- une chambre de déposition (10) ;
- un plateau (20) disposé à l'intérieur de la chambre de déposition (10) et comprenant un matériau conducteur de l'électricité, où le plateau (20) est connecté électriquement à l'alimentation électrique (24) et configuré pour supporter un composant (4) ;
- une électrode, soit disposée dans la chambre de déposition (10) soit définie par la chambre de déposition (10) où l'électrode est isolée électriquement du plateau (20) ;
- un four à pyrolyse (8), comprenant un premier élément chauffant configuré pour chauffer le four à pyrolyse (8) à une première température élevée suffisante pour causer la pyrolyse d'un dimère de poly(p-xylylène) ;
- un four vaporisateur (6), comprenant un second élément chauffant configuré pour chauffer le four vaporisateur (6) à une seconde température élevée suffisante pour causer l'évaporation du dimère de poly(p-xylylène) ;
- un premier moyen d'alimentation (16) comprenant un conduit qui s'étend entre le four à pyrolyse (8) et la chambre de déposition (10) et étant configuré pour fournir un monomère de poly(p-xylylène) au plateau (20) ; et
- un second moyen d'alimentation (14) comprenant un conduit qui s'étend entre le four vaporisateur (6) et le four à pyrolyse (8) et étant configuré pour amener le dimère de poly(p-xylylène) dans le four à pyrolyse (8),
où
(i) le plateau (20) est configuré pour supporter un composant (4) comprenant un matériau conducteur de l'électricité et l'alimentation électrique (24) est configurée pour appliquer un courant électrique au composant conducteur de l'électricité (4) supporté par le plateau (20) à une puissance comprise entre 0,0001 Watt/cm² et 10 Watts/cm² de telle sorte qu'un plasma est généré qui enveloppe le composant et ionise et/ou active le monomère de poly(p-xylylène) ;
ou où
(ii) le plateau (20) est configuré pour supporter un composant (4) constitué d'un matériau électriquement isolant et le plateau (20) comprend une plaque configurée pour recevoir le composant (4) sur elle, et l'alimentation électrique (24) est configurée pour appliquer un courant électrique au plateau (20) à une puissance comprise entre 0,0001 Watt/cm² et 10 Watts/cm² de telle sorte qu'un champ électrique est généré qui est capable de traverser le composant (4) et de créer un plasma qui enveloppe le composant et ionise et/ou active le monomère de poly(p-xylylène).

2. Appareil (2) selon la revendication 1, où le composant (4) comprend un matériau conducteur de l'électricité, et le plateau (20) comprend une pince élastique configurée pour recevoir une partie du composant conducteur de l'électricité.

3. Appareil (2) selon la revendication 1, où le composant (4) est constitué d'un matériau électriquement isolant et comporte une surface essentiellement plane et le plateau (20) comprend une plaque essentiellement plane configurée pour recevoir le composant.

4. Appareil (2) selon la revendication 3, où le composant (4) est constitué d'un matériau électriquement isolant et comporte une épaisseur inférieure à 25 cm, inférieure à 10 cm, inférieure à 7,5 cm, inférieure à 5 cm, inférieure à 3 cm, inférieure à 2 cm ou inférieure à 1 cm.

5. Appareil (2) selon l'une quelconque des revendications précédentes, où le premier moyen d'alimentation (16) comprend une vanne à vide.

6. Appareil (2) selon l'une quelconque des revendications précédentes, où la chambre de déposition (10) comprend un logement conducteur relié à la terre qui définit l'électrode ; et/ou l'appareil (2) comprend un moyen d'injection, configuré pour injecter un gaz dans la chambre de déposition (10).

7. Appareil (2) selon l'une quelconque des revendications précédentes, l'appareil (2) comprenant en outre :
- un capteur de pression disposé dans la chambre de déposition (10) ;
- un capteur de température disposé dans le four à pyrolyse (8) ;
- une pompe à vide (12) configurée pour réduire la pression de la chambre de déposition (10) à une pression inférieure à 10 Torr ; et
- un moyen de commande configuré pour :
∘ activer la pompe à vide (12) quand un utilisateur commence un premier cycle de revêtement ;
∘ activer le premier élément chauffant quand la pression dans la chambre de déposition (10) est tombée en dessous d'une première pression prédéterminée ;
∘ activer le second élément chauffant quand la température dans le four à pyrolyse (8) est montée au-dessus d'une température prédéterminée ; et
∘ activer l'alimentation électrique (24), après avoir activé les premier et second éléments chauffants et quand la pression dans la chambre de déposition (10) est montée au-dessus d'une seconde pression prédéterminée.

8. Appareil (2) selon l'une quelconque des revendications précédentes, où la première température élevée est comprise entre 200°C et 1500°C, et/ou la seconde température élevée est comprise entre 80°C et 500°C.

9. Procédé pour déposer du poly(p-xylylène) sur un composant (4), le procédé comprenant :
- le support du composant (4) sur un plateau (20) dans une chambre de déposition (10), où le plateau (2) comprend un matériau conducteur de l'électricité, est connecté à une alimentation électrique radiofréquence (24) configurée pour fonctionner à une fréquence comprise entre 1 et 100 MHz et est isolé électriquement d'une électrode ;
- la fourniture d'un monomère de poly(p-xylylène) au composant (4) ;
- l'activation de l'alimentation électrique (24) et ainsi la création d'un plasma qui enveloppe le composant (4) et ionise et/ou active le monomère de poly(p-xylylène) ; et
- le dépôt du monomère de poly(p-xylylène) ionisé et/ou activé sur le composant (4) et sa polymérisation, et ainsi la formation de poly(p-xylylène) sur le composant (4),
où
(i) le composant (4) comprend un matériau conducteur de l'électricité et l'alimentation électrique (24) applique un courant électrique au composant conducteur de l'électricité (4) à une puissance comprise entre 0,0001 Watt/cm² et 10 Watts/cm² ; ou où
(ii) le plateau (20) comprend une plaque configurée pour recevoir le composant (4) et le composant (4) est constitué d'un matériau électriquement isolant et l'alimentation électrique (24) applique un courant électrique au plateau (20) à une puissance comprise entre 0,0001 Watt/cm² et 10 Watts/cm² de telle sorte qu'un champ électrique est généré, qui est capable de traverser le composant (4) et de créer le plasma.

10. Procédé selon la revendication 9, où la fourniture du monomère de poly(p-xylylène) au composant (4) comprend la fourniture du monomère de poly(p-xylylène) dans la chambre de déposition (10), faisant ainsi monter la pression dans la chambre de déposition (10), et le procédé comprend l'activation de l'alimentation électrique (24) après que la pression dans la chambre de déposition (10) atteint une pression prédéterminée.

11. Procédé selon la revendication 10 où, avant la fourniture du monomère de poly(p-xylylène) dans la chambre de déposition (10), le procédé comprend la réduction de la pression dans la chambre de déposition (10) à moins de 10 Torr.

12. Procédé selon l'une quelconque des revendications 9 à 11, le procédé comprenant la désactivation de l'alimentation électrique (24) un temps prédéterminé après son activation ou lorsqu'une couche déposée sur le composant (4) a atteint une épaisseur voulue.

13. Procédé selon la revendication 12, le procédé comprenant la mise à l'atmosphère de la chambre de déposition (10) après la désactivation de l'alimentation électrique (24).
